Europäisches Patentamt

(19) European Patent Office

Office européen des brevets

(11) Numéro de publication: **0 231 544**
**B1**

(12) **FASCICULE DE BREVET EUROPEEN**

(45) Date de publication du fascicule du brevet:
28.03.90

(51) Int. Cl.⁴: **C30B 25/10, C30B 25/16**

(21) Numéro de dépôt: **86202229.0**

(22) Date de dépôt: **10.12.86**

(54) Chambre de réacteur pour croissance épitaxiale en phase vapeur des matériaux semi-conducteurs.

(30) Priorité: **17.12.85 FR 8518677**

(43) Date de publication de la demande:
**12.08.87 Bulletin 87/33**

(45) Mention de la délivrance du brevet:
**28.03.90 Bulletin 90/13**

(84) Etats contractants désignés:
**DE FR GB IT NL**

(56) Documents cités:
FR-A- 1 430 174
US-A- 3 316 121

JOURNAL OF CRYSTAL GROWTH,
vol. 70, no. 1/2, décembre 1984, pages 140-144, Elsevier
Science Publishers B.V., Amsterdam, NL; A. OKAMOTO
et al.: "Extremely uniform growth of GaAs and GaAlAs
by low pressure metalorganic chemical vapor
deposition on three-inch GaAs substrates" Seiten 1-6
000

(73) Titulaire: **LABORATOIRES D'ELECTRONIQUE PHILIPS,
3, Avenue Descartes, F-94450 Limeil-Brévannes(FR)**
(84) Etats contractants désignés: **FR**

(73) Titulaire: **N.V. Philips' Gloeilampenfabrieken,
Groenewoudseweg 1, NL-5621 BA Eindhoven(NL)**
(84) Etats contractants désignés: **DE GB IT NL**

(72) Inventeur: **Frijlink, Peter Michael Sté Civile S.P.I.D.,
209 rue de l'Université, F-75007 Paris(FR)**

(74) Mandataire: **Landousy, Christian et al, Société Civile
S.P.I.D. 209, Rue de l'Université, F-75007 Paris(FR)**

# Description

L'invention concerne une chambre de réacteur pour effectuer la croissance épitaxiale en phase vapeur de couches de matériaux semiconducteurs sur des substrats semiconducteurs, cette chambre contenant un porte-échantillon pour le substrat, et chambre dans laquelle circulent parallèlement au substrat des composés gazeux sous une pression et une température appropriées à obtenir la croissance épitaxiale des couches monocristallines sur le substrat.

L'invention trouve son application dans la réalisation de composants discrets tels que : lasers à semiconducteurs, photodiodes, photocathodes, transistors à effet de champ, transistors bipolaires à hétérojonction, et dans la réalisation de circuits intégrés réunissant un ou plusieurs type de ces composants.

Un état de l'art, concernant la réalisation de couches épitaxiales en phase vapeur, de matériaux du groupe III-V est bien décrit dans la revue ACTA ELECTRONICA, 21, 2, 1978. L'article de L. Hollan, intitulé "La croissance épitaxiale de GaAs en phase vapeur" p.117-127, et l'article de J.P. Hallais, intitulé "Croissance épitaxiale de semiconducteurs III-V à partir de composés organométalliques et d'hydrures" p. 129-138, donne le premier l'enseignement pour réaliser des couches épitaxiales sur substrat GaAs par la méthode en phase vapeur, aux chlorures, et le second pour réaliser de telles couches par la méthode en phase vapeur aux organométalliques. D'autres articles de la même revue traitent le cas du phosphure d'indium et du nitrure de gallium.

Les méthodes généralement employées ont en commun l'introduction, dans un réacteur, de composés gazeux à partir desquels, est effectuée la croissance en phase vapeur. Ce réacteur a en général la forme d'un tube en quartz. Les substrats, ou amorces, sont disposés dans le tube, sur un porte-échantillon. Les couches monocristallines croissent sur les substrats au passage des composés gazeux. Les documents cités comme état de la technique enseignent (p. 132) que la vitesse de dépôt dépend essentiellement de la composition du flux gazeux, mais non pas de la température de dépôt. On notera (p.130) que dans la méthode dite au organométalliques, des réacteurs à parois froides sont recommandés.

Dans le domaine des dispositifs semiconducteurs réalisés à partir des composés du groupe III-V, la qualité des couches épitaxiales est de la plus haute importance pour obtenir un bon rendement de fabrication.

Comme les dispositifs semiconducteurs réalisés à partir de matériaux du groupe III-V sont appelés à prendre un grand développement dans l'avenir, il est évidemment recherché d'améliorer la qualité des couches dont sont faits ces dispositifs, dans le but de faciliter l'obtention de ces derniers.

Une des méthodes consiste donc à améliorer la qualité des couches épitaxiales.

Or dans l'état actuel de la technique, ces couches ne sont généralement pas uniformes en épaisseur. On constate que les couches réalisées par épitaxie en phase vapeur sont plus épaisses du côté où le flux gazeux entre dans la chambre du réacteur, que du côté où il sort. On constate en outre que non seulement la vitesse de croissance n'est pas constante tout le long de l'axe de l'échantillon, mais encore que la diminution de cette vitesse n'est pas linéaire. La courbe des vitesses de croissance tracées en fonction de la distance mesurée sur l'axe de l'échantillon parallèlement au flux des gaz, est une courbe décroissante, et dont la pente décroît également. On constate en outre que la composition de ces couches, ou leur dopage, n'est pas uniforme.

C'est pourquoi, la présente invention propose un dispositif qui permet d'améliorer l'uniformité des couches épitaxiales réalisées en phase vapeur, et donc la qualité des dispositifs semiconducteurs réalisés à l'aide de ces couches.

Selon la présente invention le but est atteint à l'aide d'une chambre de réacteur telle que décrite dans le préambule, caractérisée en ce qu'elle est équipée d'un premier moyen consistant en un dispositif de chauffage, piloté, de la partie de la paroi de la chambre opposée au porte-échantillon, cette partie de paroi étant dite plafond de la chambre, pour provoquer des variations du profil de température de ce plafond, d'un second moyen consistant en un dispositif de chauffage, piloté, du porte-échantillon pour provoquer des variations du profil de température de ce porte-échantillon indépendamment de celles du plafond de la chambre, et d'un troisième moyen consistant en un dispositif de rotation du porte-échantillon autour d'un axe perpendiculaire à son plan, ces trois moyens coopérant pour qu'en chaque point du substrat d'une part le taux de croissance soit uniforme et d'autre part la composition de la couche épitaxiale soit uniforme.

Dans un cas cette chambre pourra être caractérisée en ce que le dispositif de chauffage du plafond est piloté pour obtenir pour la couche épitaxiale, lorsque l'échantillon est immobile, un profil de dépôt selon une fonction antisymétrique par rapport à un point de l'échantillon pris comme origine.

Dans un autre cas, cette chambre est caractérisée en ce que le dispositif de chauffage du plafond est piloté pour obtenir une diminution linéaire uniforme du taux de croissance des couches parallèlement à la direction dite longitudinale de circulation du flux gazeux, lorsque l'échantillon est immobile.

En outre, cette chambre pourra être caractérisée en ce que l'axe de rotation est placé au centre d'antisymétrie du profil obtenu en l'absence de rotation, de sorte que par rotation autour de cet axe l'uniformité du dépôt est obtenue.

En outre, cette chambre pourra être caractérisée en ce que le dispositif de chauffage du porte-échantillon est piloté pour obtenir en combinaison avec le pilotage de la température du plafond de la chambre un profil de température de ce porte-échantillon selon une fonction antisymétrique par rapport à l'axe de rotation du porte-échantillon pris comme origine, lorsque l'échantillon est immobile, de sorte que par rotation autour de cet axe l'uniformité de la composition de la couche épitaxiale est obtenue.

Donc selon la présente invention, le pilotage de la température du plafond produit une action sur le profil du dépôt de la couche épitaxiale, au contraire des essais qui avaient été pratiqués dans l'art antérieur et qui montraient que la vitesse de dépôt ne dépend pas de la température de dépôt et que d'autre part, dans l'une des deux méthodes préconisées (aux organométalliques) il était recommandé d'éviter l'échauffement des parois du réacteur. Ainsi, selon l'invention, des couches d'épaisseur constante peuvent être obtenues. De plus, un pilotage de la température du porte-échantillon selon un principe identique mais indépendant, permet d'obtenir l'optimisation de l'homogénéité de la composition de la couche.

L'invention sera mieux comprise à l'aide de la description suivante illustrée par les figures annexées dont :

- la figure 1 qui représente la chambre de dépôt d'un réacteur d'épitaxie en phase vapeur ;
- la figure 2 qui représente la courbe de vitesse de dépôt épitaxial sur un substrat en fonction de la distance mesurée sur l'échantillon parallèlement au flux des gaz :
  a) en trait plein lorsque la chambre n'est pas pourvue du dispositif de pilotage de la température, selon l'invention,
  b) en trait discontinu, lorsque la chambre est pourvue du dispositif de pilotage de la température selon l'invention ;
- la figure 3 qui représente une courbe de variation de la température du plafond en fonction de la distance mesurée parallèlement à la direction du flux des gaz, dans une chambre munie du dispositif de pilotage selon l'invention ;
- les figures 4 qui montrent la relation entre la linéarité de la vitesse du dépôt en l'absence de rotation du porte-échantillon et la constante de la vitesse du dépôt en présence de la rotation du porte-échantillon dans une chambre d'épitaxie selon l'invention ;
- les figures 5 qui montrent respectivement, pour la figure 5a les isothermes en fonction de la distance mesurée le long de l'échantillon chauffé, les isobares pour la figure 5b, et le profil des vitesses pour la figure 5c ;
- la figure 6 qui montre un exemple de taux de croissance dont la courbe représentative en fonction de la distance mesurée le long de l'échantillon est une fonction antisymétrique, si l'on prend la position de l'axe de rotation comme origine.

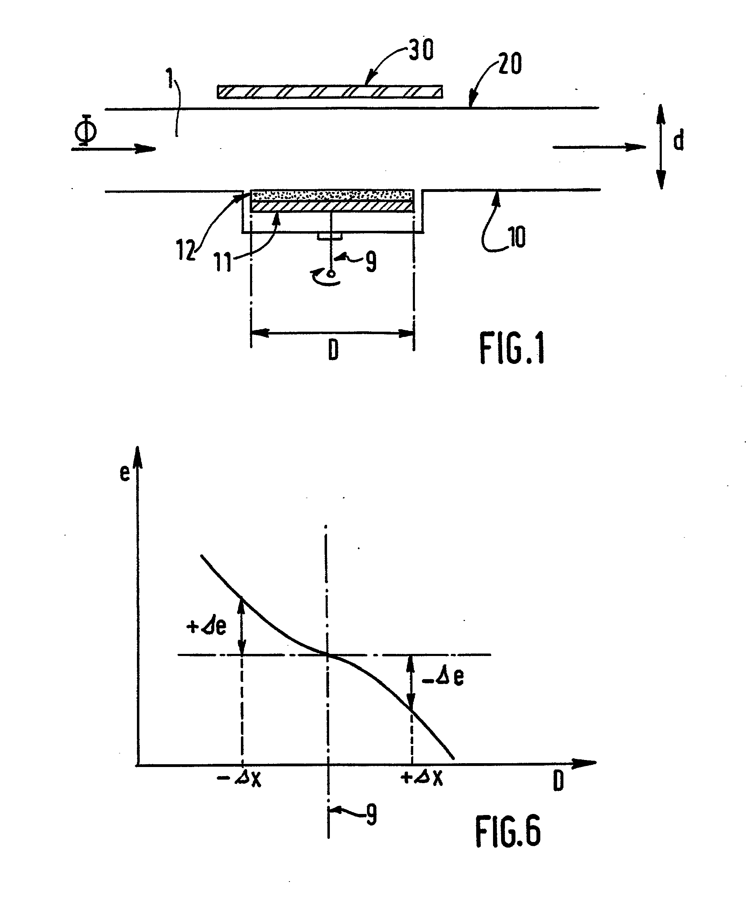

Telle que représentée sur la figure 1 la chambre 1 de dépôt d'un réacteur pour l'élaboration de couches épitaxiales est essentiellement formée d'une partie d'un tube en quartz, et peut être de section rectangulaire.

Au niveau de la paroi inférieure 10 de la chambre est disposé un support d'échantillon, dit porte-échantillon 11 du substrat 12. La paroi supérieure ou plafond 20 de la chambre est très rapprochée de l'échantillon. La distance mesurée entre la surface de l'échantillon et le plafond est d.

Le flux Φ des composés gazeux nécessaires à la croissance épitaxiale est parallèle à la surface de l'échantillon. L'entrée et la sortie des gaz sont situées de part et d'autre de l'échantillon. La distance mesurée le long de l'échantillon selon la direction du flux Φ est D.

Dans l'exemple considéré ici, de réalisation de couches épitaxiales sur un substrat monocristallin massif 12 en arséniure de gallium (GaAs) ou en phosphure d'indium (InP), le flux Φ des composés gazeux est en grande partie constitué d'hydrogène (H₂) auquel est mêlé de l'arsine (AsH₃) et/ou de la phosphine (PH₃) et/ou un composé organométallique d'un élément du groupe III.

En effet, si les éléments du groupe V se trouvent facilement sous forme volatile, en revanche les éléments du groupe III, qui n'ont pas une tension de vapeur utilisable pour le transport à la température de croissance, doivent être introduits par exemple sous forme de chlorures, ou encore sous forme d'un composé organométallique. Le gaz hydrogène est utilisé au titre de gaz vecteur. La température de croissance des couches épitaxiales réalisées à partir de ces éléments de départ est située entre 500 et 850°C.

Le porte-échantillon, par exemple en graphite, muni d'un substrat par exemple en arséniure de gallium (GaAs) est chauffé par un dispositif permettant un pilotage de sa température principalement dans le sens de propagation du flux et un contrôle de cette température par exemple par thermocouples. Les publications citées comme état de la technique enseignent que la vitesse de croissance ne dépend pas de la température d'épitaxie dans la gamme 500 à 850°C.

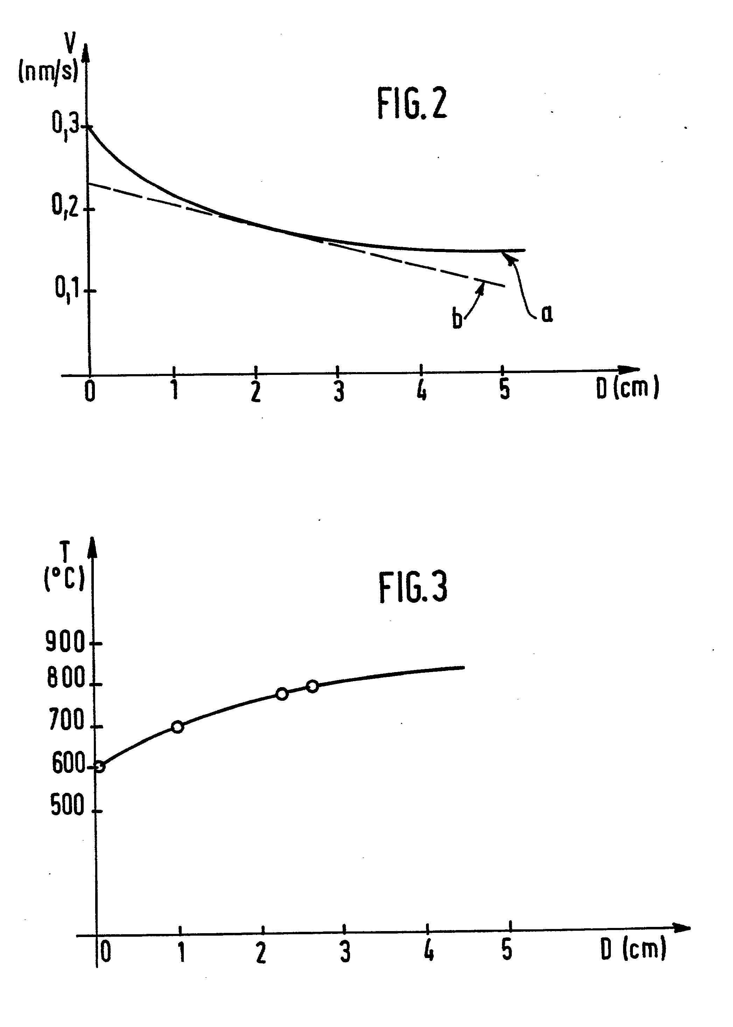

Cependant, on constate comme il est montré sur la courbe en trait plein a) de la figure 2, que la vitesse de croissance V (en nm/S) donnée en fonction de la distance D (en cm) mesurée le long de l'axe d'un échantillon parallèlement à la direction du flux des composés gazeux, n'est pas constante dans une chambre de type conventionnel.

Cette courbe montre que la vitesse de croissance est très élevée du côté où sont introduits les composés gazeux et qu'elle diminue d'abord très vite puis plus lentement du côté de l'échantillon situé vers la sortie du flux gazeux.

Donc, non seulement la vitesse de croissance diminue, de l'entrée vers la sortie du flux gazeux, mais encore cette diminution n'est pas linéaire, la courbe a) montrant une pente qui est également décroissante en fonction de la distance mesurée le long de D.

Selon l'invention, un dispositif de pilotage 30 de la température de la paroi 20 opposée au porte-échantillon, ou plafond de la chambre, est installé. On notera bien que ce dispositif de pilotage de la température de la paroi opposée au porte-échantillon est complètement distinct du dispositif de chauffage et de pilotage de la température du porte-échantillon. Le fait de rendre ces deux dispositifs distincts permet :

- d'obtenir un profil de température du plafond de la chambre différent du profil de température du porte-échantillon,
- et permet donc d'obtenir un degré de liberté supplémentaire dans le contrôle du taux de croissance et du taux de dopage d'une couche épitaxiale réalisée dans une chambre conforme à l'invention. En effet le pilotage de la température du plafond de la chambre permet essentiellement le contrôle du taux de croissance de la couche, alors que le contrôle de la température du porte-échantillon permet essentiellement le contrôle du taux de dopage.

Ce dispositif est, de façon avantageuse constitué par un dispositif de chauffage du plafond de la chambre de dépôt, qui pourra être réalisé au moyen de résistances chauffantes. Cependant selon l'invention, le chauffage du plafond de la chambre n'est pas réalisé uniformément. La température du plafond de la chambre est contrôlée en pilotant ce dispositif de chauffage de manière à obtenir au contraire à la surface de ce plafond une répartition non uniforme de la température.

En faisant varier le pilotage du dispositif de chauffage du plafond de la chambre, et donc en imposant une répartition non uniforme de la température de ce plafond, de façon contrôlée, on atteint le but qui était visé, à savoir une diminution linéaire uniforme de la vitesse de croissance des couches dans la direction de circulation du flux gazeux. On obtient donc la courbe b) de la figure 2, représentée en trait discontinu et obtenue dans les mêmes conditions de température du porte-échantillon et de pression des gaz.

La figure 3 montre un profil de la température T contrôlée du plafond de la chambre qui est particulièrement favorable à l'obtention d'une courbe b) de la figure 2 décroissant linéairement. Cette courbe de la figure 3 est globalement croissante en fonction de la distance mesurée sur l'axe de l'échantillon dans la direction du flux. De façon avantageuse, elle présente même une pente décroissante en fonction de la distance mesurée le long de D.

Il est évident que l'obtention d'un profil idéal de la courbe de température du plafond, représentée figure 3, est éminemment fonction :
- de la température de croissance,
- de la température du porte-échantillon,
- de la pression totale des gaz,
- des pressions partielles des gaz,
- du type de matériau à déposer,
- de la dimension de la chambre de dépôt.

Ces paramètres qui sont nombreux, rendent nécessaire un étalonnage préalable du dispositif de pilotage de la température du plafond de la chambre, ou encore l'emploi d'un petit programme d'ordinateur pour le pilotage du chauffage du plafond de la chambre.

De telles techniques sont coutumières de l'homme du métier et ne requièrent pas d'autres travaux que l'étalonnage pas à pas, ou par programme, jusqu'à l'obtention de la courbe b) de la figure 2, décroissant linéairement.

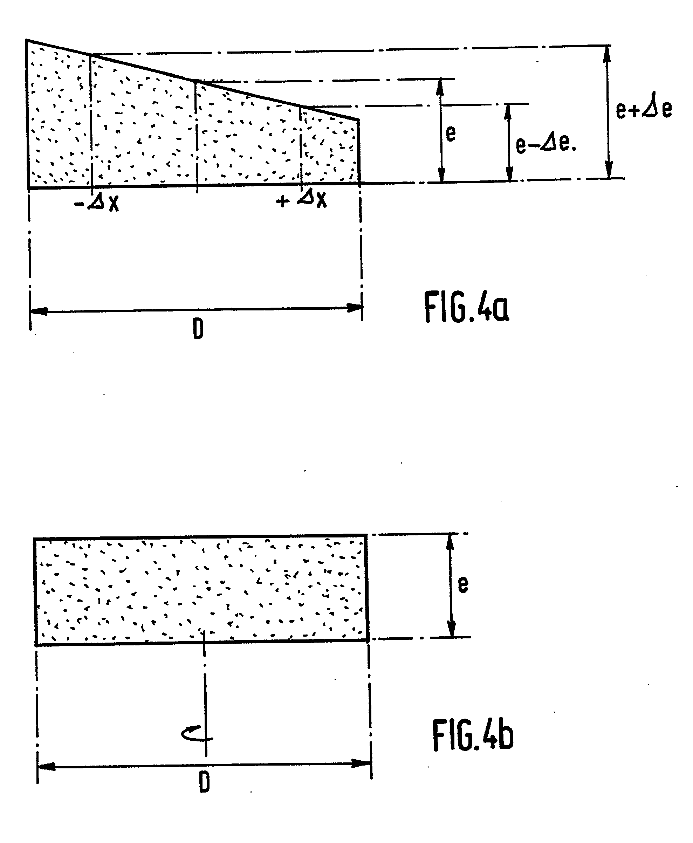

Lorsque la linéarité de la diminution du taux de croissance est obtenue, les figures 4 montrent clairement comment, alors par simple rotation de l'échantillon, ce dernier voit croître sur sa surface une couche d'épaisseur constante.

En effet, en l'absence de rotation, l'échantillon 12 recevrait en son centre $\underline{O}$ une couche d'épaisseur $\underline{e}$, et deux points de l'échantillon situés respectivement à la distance $+ \Delta x$ du point $\underline{O}$, et la distance $-\Delta$ x du point O, recevraient une couche d'épaisseur respectivement $e - \Delta e$, et $e + \Delta e$ (figure 4a).

Lorsque l'échantillon 12 est soumis à une rotation au moyen de son porte-échantillon 11, qui tourne autour d'un axe perpendiculaire à son plan, le manque d'épaisseur $- \Delta e$ est compensé par la surépaisseur $+ \Delta e$, et l'épaisseur de la couche qui croît sur l'échantillon est constante et égale à $\underline{e}$.

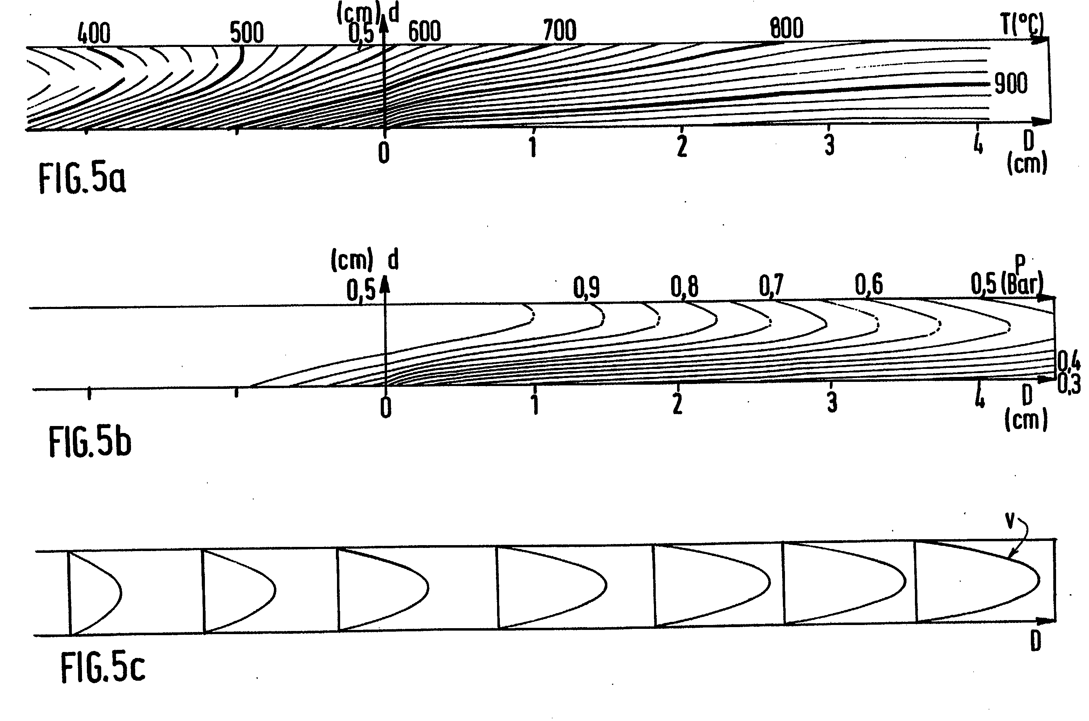

Dans un exemple de réalisation où la distance $\underline{d}$ entre l'échantillon et le plafond 20 est 0,5 cm, où la température de dépôt est T(°C), où la pression partielle d'organométallique est p en Bar, et v la vitesse du gaz en unités arbitraires, les figures 5 montrent respectivement, dans la coupe de la figure 1, le relevé des isothermes (figure 5a), les isobares de pression partielle d'organométalliques normalisées à la pression partielle d'entrée (figure 5b), les profils de vitesse du gaz en unités arbitraires (figure 5c). La distance D mesurée le long de l'échantillon est notée à partir du début O du porte-échantillon chauffé. On notera que les profils de vitesse deviennent très peu différents d'une parabole parfaite. L'écoulement des gaz est laminaire.

Dans un autre exemple de réalisation cependant, l'écoulement des gaz pourrait être turbulent et l'invention parfaitement applicable.

Dans une autre mise en oeuvre de l'invention, on ne cherchera pas à obtenir par pilotage de la température du plafond, une courbe de diminution du taux de croissance qui est linéaire et uniforme, comme représentée dans la figure 2, courbe b.

On cherchera au contraire à obtenir que la déviation du taux de croissance par rapport au centre de rotation soit une fonction antisymétrique dont l'origine est repérée par rapport au centre de rotation. Une telle fonction est par exemple représentée par la courbe de la figure 6. Dans le cas où l'on obtient par chauffage du plafond, un taux de croissance tel que celui représenté figure 6, alors, par rotation de l'échantillon autour d'un axe 9 placé en 0, l'uniformité de l'épaisseur de la couche peut être obtenue.

Dans une autre mise en oeuvre de l'invention, on partira simplement de la constatation déduite de la courbe a de la figure 2, que la couche déposée sur l'échantillon, lorsque la température du plafond n'est pas pilotée, présente dans la direction parallèle au flux un profil d'épaisseur concave, dont la concavité est tournée vers le porte-échantillon, en sorte que, en cas de rotation de l'échantillon, les bords de la couche sont plus épais que le centre.

Au moyen du pilotage de la température du plafond de la chambre, on cherchera à compenser ce défaut de matière en rendant convexe le profil d'épaisseur de la couche dans la direction perpendiculaire au défaut, c'est-à-dire perpendiculairement à la direction des flux gazeux. Ceci peut être obtenu par exemple en plaçant des résistances chauffantes à proximité du plafond de la chambre, orientées parallèlement aux flux $\Phi$, de telle sorte que les isothermes au plafond sont alors orientés parallèlement au flux $\Phi$.

Lorsque ce nouveau profil d'épaisseur de couche est ainsi obtenu, alors par rotation de l'échantillon on obtient la compensation de l'épaisseur du dépôt, et par là une couche uniforme.

Dans une autre mise en oeuvre de l'invention la courbe obtenue par pilotage de la température de la chambre est une courbe complexe non représentée, composée de plusieurs fonctions décrites précédemment, mais telle que par rotation autour de l'axe, une parfaite compensation géométrique est obtenue, chaque manque d'épaisseur - $\Delta e$ étant toujours compensée par une surépaisseur + $\Delta e$ lors de cette rotation.

Ces différentes méthodes proposées présentent l'avantage que l'on peut adapter le profil thermique du plafond, aux conditions expérimentales, ainsi qu'à la nature du matériau à déposer.

Enfin selon l'invention un pilotage de la température du porte-échantillon selon un principe identique à celui qui est décrit pour le plafond de la chambre est réalisé. Ce pilotage permet d'optimiser l'uniformité du dopage des couches épitaxiales. Le dispositif de chauffage du porte-échantillon pourra être constitué, comme celui du plafond, par des résistances chauffantes. Le contrôle de la température en différents points du porte-échantillon sera lié au contrôle de la température en différents points du plafond de manière à obtenir la coopération des moyens constitués par les dispositifs de chauffage et la rotation, en vue d'optimiser la qualité des couches épitaxiales.

De cette manière, on peut obtenir à la fois des couches d'épaisseur uniforme, et des couches de composition homogène, ou de dopage homogène, en partant d'un réacteur conventionnel dans lequel on fait simplement varier le pilotage électrique du chauffage du plafond de la chambre du réacteur et du porte-échantillon indépendamment l'un de l'autre mais en même temps.

## Revendications

1: Chambre de réacteur pour effectuer la croissance épitaxiale en phase vapeur de couches de matériaux semiconducteurs sur des substrats semiconducteurs, cette chambre contenant un porte-échantillon pour le substrat, et chambre dans laquelle circule parallèlement au substrat des composés gazeux sous une pression et une température appropriées à obtenir la croissance épitaxiale des couches monocristallines sur le substrat, caractérisée en ce qu'elle est équipée d'un premier moyen consistant en un dispositif de chauffage piloté de la partie de la paroi de la chambre opposée au porte-échantillon, cette partie de paroi étant dite plafond de la chambre, pour provoquer des variations du profil de température de ce plafond, d'un second moyen consistant en un dispositif de chauffage piloté du porte-échantillon pour provoquer des variations du profil de température de ce porte-échantillon indépendamment de celles du plafond de la chambre, et d'un troisième moyen consistant en un dispositif de rotation du porte-échantillon autour d'un axe perpendiculaire à son plan, ces trois moyens coopérant pour qu'en chaque point du substrat d'une part le taux de croissance soit uniforme et d'autre part la composition de la couche épitaxiale soit uniforme.

2. Chambre selon la revendication 1, caractérisée en ce que le dispositif de chauffage du plafond est piloté pour obtenir pour la couche épitaxiale, lorsque l'échantillon est immobile, un profil de dépôt selon une fonction antisymétrique par rapport à un point de l'échantillon pris comme origine.

3. Chambre selon la revendication 2, caractérisée en ce que le dispositif de chauffage du plafond est piloté pour obtenir une diminution linéaire uniforme du taux de croissance des couches parallèlement à la direction dite longitudinale de circulation du flux gazeux, lorsque l'échantillon est immobile.

4. Chambre selon l'une des revendications 2 ou 3, caractérisée en ce que l'axe de rotation est placé au centre d'antisymétrie du profil obtenu en l'absence de rotation, de sorte que par rotation autour de cet axe l'uniformité du dépôt est obtenue.

5. Chambre selon l'une des revendications 1 à 4, caractérisée en ce que le dispositif de chauffage du porte-échantillon est piloté pour obtenir en combinaison avec le pilotage de la température du plafond de la chambre un profil de température de ce porte-échantillon selon une fonction antisymétrique par rapport à l'axe de rotation du porte-échantillon pris comme origine, lorsque l'échantillon est immobile, de sorte que par rotation autour de cet axe l'uniformité de la composition de la couche épitaxiale est obtenue.

6. Chambre selon l'une des revendications 1 à 5, caractérisée en ce que le chauffage du plafond de la chambre d'une part et le chauffage du porte-échantillon d'autre part sont obtenus au moyen de résistances chauffantes et en ce que le pilotage de la température du plafond et celui du porte-échantillon sont obtenus par le contrôle discret de la température de ces résistances.

7. Utilisation d'une chambre selon l'une des revendications 1 à 6 à la réalisation de couches épitaxiales de matériaux du groupe III-V sur un substrat du groupe III-V par la méthode dite aux organométalliques pour obtenir des couches soit de propriétés homogènes soit d'épaisseur uniforme.

## Patentansprüche

1. Reaktionskammer zur Epitaxialkristallzüchtung in der Dampfphase von Schichten aus Halbleitermaterial auf Halbleitersubstraten, wobei die Kammer einen Scheibenträger für das Substrat aufweist und in derselben parallel zum Substrat Gaszusammensetzungen umlaufen mit einem Druck und einer Temperatur, die zur Epitaxialzüchtung monokristalliner Schichten auf dem Substrat geeignet sind, dadurch gekennzeichnet, daß sie mit einem ersten Mittel versehen ist, das aus einer gesteuerten Heizvorrichtung besteht zum Erhitzen desjenigen Teils der Wand der Kammer, der gegenüber dem Scheibenträger liegt, wobei dieser Teil der Wand als Decke der Kammer bezeichnet wird, zum Erzeugen von Änderungen im Temperaturprofil dieser Decke, weiterhin mit einem zweiten Mittel, das aus einer gesteuerten Heizvorrichtung besteht zum Erhitzen des Scheibenträgers zum Erzeugen von Änderungen im Temperaturprofil dieses Scheibenträgers, unabhängig von den Temperaturprofiländerungen der Decke der Kammer, und mit einem dritten Mittel, das aus einer Drehvorrichtung für den Scheibenträger besteht, zum Drehen desselben um eine Achse senkrecht zu dessen Ebene, wobei diese drei Mittel miteinander zusammenarbeiten, damit an jeder Stelle des Substrats einerseits das Zuchtverhältnis einheitlich ist und andererseits die Zusammensetzung der Epitaxialschicht einheitlich ist.

2. Kammer nach Anspruch 1, dadurch gekennzeichnet, daß die Heizvorrichtung für die Decke gesteuert wird, damit, wenn die Scheibe unbeweglich ist, für die Epitaxialschicht ein Niederschlagsprofil erhalten wird entsprechend einer antisymmetrischen Funktion gegenüber einem Punkt der Scheibe, der als Ursprung gewählt wird.

3. Kammer nach Anspruch 2, dadurch gekennzeichnet, daß die Heizvorrichtung für die Decke gesteuert wird, damit eine einheitliche lineare Verringerung des Zuchtverhältnisses der Schichten parallel zu der sog. Längsrichtung des Umlaufes des Gasflusses erhalten wird, wenn die Scheibe unbeweglich ist.

4. Kammer nach einem der Ansprüche 2 oder 3, dadurch gekennzeichnet, daß die Drehungsachse in die Antisymmetriemitte des Profils gestellt wird, das erhalten wird beim Fehlen einer Drehbewegung, derart, daß durch Drehung um diese Achse die Einheitlichkeit des Niederschlages erzielt wird.

5. Kammer nach einem der Ansprüche 1 bis 4, dadurch gekennzeichnet, daß die Heizvorrichtung des Scheibenträgers gesteuert wird, damit zusammen mit der Steuerung der Temperatur der Decke der Kammer ein Temperaturprofil dieses Scheibenträgers erhalten wird, entsprechend einer Antisymmetriefunktion gegenüber der als Ursprung gewählten Drehungsachse des Scheibenträgers, wenn die Scheibe unbeweglich ist, derart, daß durch Drehung um diese Achse die Einheitlichkeit der Zusammensetzung der Epitaxialschicht erhalten wird.

6. Kammer nach einem der Ansprüche 1 bis 5, dadurch gekennzeichnet, daß die Erhitzung der Decke der Kammer einerseits und die Erhitzung des Scheibenträgers andererseits durch Heizwiderstände erhalten wird und daß die Steuerung der Temperatur der Decke und die der Scheibe durch die diskrete Regelung der Temperatur dieser Widerstände erhalten wird.

7. Verwendung einer Kammer nach einem der Ansprüche 1 bis 6 zum Herstellen von Epitaxialschichten aus Halbleitermaterial der Gruppe III–V auf einem Substrat der Gruppe III–V durch das Verfahren unter Vewendung organometallischer Zusammensetzungen zum Erhalten von Schichten entweder mit homogenen Eigenschaften oder mit einer einheitlichen Dicke.

## Claims

1. A reactor chamber for carrying out the epitaxial growth from the vapour phase of layers of semiconductor materials on semiconductor substrates, this chamber containing a sample carrier for the substrate, while in this chamber circulate parallel to the substrate gaseous compounds at a pressure and a temperature suitable to obtain the epitaxial growth of the monocrystalline layers on the substrate, characterized in that it is provided with a first means consisting of a regulated device for heating the part of the wall of the chambre opposite to the sample carrier, this wall part being designated as the ceiling of the chamber, in order to produce variations of the temperature profile at said ceiling, with a second means consisting of a regulated device for heating the sample carrier in order to produce variations of the temperature profile of said sample carrier independently of those of the ceiling of the chamber, and with a third means consisting of a device for rotating the sample carrier about an axis perpendicular to said plane, these three means cooperating in such a manner that at each point of the substrate on the one hand the rate of growth is uniform and on the other hand the composition of the epitaxial layer is uniform.

2. A chamber as claimed in claim 1, characterized in that the device for heating the ceiling is regulated so as to obtain for the epitaxial layer, when the sample is stationary, a deposition profile according to a function which is anti-symmetrical with respect to a point of the sample taken as the origin.

3. A chamber as claimed in claim 2, characterized in that the device for heating the ceiling the ceiling is regulated so as to obtain a linear uniform diminution of the rate of growth of the layers parallel to the so-called longitudinal direction of circulation of the flow of gas when the sample is stationary.

4. A chamber as claimed in claims 2 or 3, characterized in that the axis of rotation is arranged at the centre of anti-symmetry of the profile obtained in the absence of rotation so that by rotation about said axis the uniformity of the deposition is obtained.

5. A chamber as claimed in any one of claims 1 to 4, characterized in that the device for heating the sample carrier is regulated so as to obtain in conjunction with the regulation of the temperature of the ceiling of the chamber a temperature profile of said sample carrier according to a function which is anti-symmetrical with respect to the axis of rotation of the sample carrier taken as the origin when the sample is stationary so that by rotation about said axis the uniformity of the composition of the epitaxial layer is obtained.

6. A chamber as claimed in any one of claims 1 to 5, characterized in that the heating of the ceiling of the chamber on the one hand and the heating of the sample carrier on the other hand are obtained by means of heating resistors, and in that the regulation of the temperature of the ceiling and that of the sample carrier are obtained by the discrete control of the temperature of these resistors.

7. Use of a chamber as claimed in any one of claims 1 to 6 for the formation of epitaxial layers of materials of the III–V group on a substrate of the III–V group by the so-called metal-organic method for obtaining layers either having homogeneous properties or having a uniform thickness.

FIG.1

FIG.6

FIG. 2

FIG. 3

FIG.4a

FIG.4b

FIG.5a

FIG.5b

FIG.5c